Europäisches Patentamt

European Patent Office

Office européen des brevets

(11) Publication number: **0 139 101**
**B1**

(12) ## EUROPEAN PATENT SPECIFICATION

(45) Date of publication of patent specification: **12.04.89**

(21) Application number: **84108327.2**

(22) Date of filing: **16.07.84**

(51) Int. Cl.⁴: **H 01 R 23/68,** H 05 K 7/14,
H 01 R 23/70

(54) A connector assembly for locating two opposed edges of a component carrier.

(30) Priority: **26.10.83 US 545702**

(43) Date of publication of application:
**02.05.85 Bulletin 85/18**

(45) Publication of the grant of the patent:
**12.04.89 Bulletin 89/15**

(84) Designated Contracting States:
**CH DE FR GB IT LI NL SE**

(56) References cited:
**EP-A-0 036 264**
**DE-A-2 611 446**
**DE-A-2 743 042**

(73) Proprietor: **International Business Machines Corporation**
**Old Orchard Road**
**Armonk, N.Y. 10504 (US)**

(72) Inventor: **Gillett, John Brian**
**Riverview Terrace**
**Kingston New York 12401 (US)**

(74) Representative: **Grant, Iain Murray**
**IBM United Kingdom Limited Intellectual**
**Property Department Hursley Park**
**Winchester Hampshire SO21 2JN (GB)**

Courier Press, Leamington Spa, England.

## Description

The invention relates to a connector assembly for locating two opposed edges of a component carrier and is directed to the problem of trying to ensure correct and positive electrical connection between the carrier and the assembly even when operated by unskilled operators.

Various zero insertion force (ZIF) connectors exist for receiving a printed circuit board edge with electrical contact areas disposed thereon. These connectors typically have actuating mechanisms, including camming means and the like, for moving rows of contact pins into and out of a board insertion path.

In the characteristic action of these known ZIF connectors, the contact pins are moved out of the board insertion path for inserting and extracting the printed circuit board into and out of the ZIF connector. The pins are moved into the board insertion path when a board is present within the connector in order to effect engagement between the contact pins of the ZIF connector and the contact areas disposed on the surface of the printed circuit board.

The action of the individual contact pins engaging the electrical contact areas of the printed circuit board usually includes a wipe action whereby surface oxide film, dust particles, or other foreign substances are removed from the contact areas and contact pins to insure a positive electrical connection.

These ZIF connectors with wipe action have enjoyed widespread application in the digital processing area where circuit density and miniturisation are constantly increasing. Increased circuit density allows more components to be placed on a single printed circuit board which consequently increases the number and density of contact areas disposed along the edges of the board.

As the number of edge contact areas increases, the wiping force also increases. The wiping force eventually reaches a point where, during attempted wipe action, the contact pins move the printed circuit board rather than wipe the surface of the board. This effect is highly undesirable because the benefits of the wipe action are lost and electrical contact integrity is degraded.

Solutions to this problem have, heretofore, required special printed circuit board shapes, including holes and notches, which mate with latching mechanisms incorporated in the zero insertion force connector. These configurations unnecessarily increase the complexity and cost of the connector and board. Also, these latching mechanisms do not lend themselves to the use in opposing connector pairs due to critical mechanical alignment requirements.

The invention provides a connector assembly for locating two opposed edges of an electronic component carrier and for making electrical edge connection between such carrier and the assembly while permitting zero insertion force entry of the carrier into the assembly, the assembly comprising a zero insertion force connector in opposition to a slotted locator provided with a stop, the zero insertion force connector having actuator means, for advancing and closing contact pins, forming part thereof, onto such carrier, characterised in that resilient means are provided in the zero insertion force connector, effective on a actuation of that connector, to bias such carrier onto the opposed stop before the contact pins of that connector can close on such carrier and, if the carrier is adapted to have electrical edge connection made to both located opposed edges, the locator is a second zero insertion force connection and both connectors are provided with resilient means and stops.

Alternatively, the present invention provides a connector assembly for locating two opposed edges of an electronic component carrier and for making electrical edge connection between such carrier and the assembly while permitting zero insertion force entry of the carrier into the assembly, the assembly comprising a pair of identical zero insertion force connectors in opposition to each other, each being provided with actuator means, for advancing and closing contact pins, forming part thereof, onto such carrier, characterised in that each connector is provided with a stop and resilient means, the resilient means being effective on actuation of the connector on which such resilient means are mounted, to bias the carrier onto the stop of the opposed connector before the contact pins of the connector being actuated can close on such carrier.

The above arrangements solve the aforementioned problems by providing an inexpensive ZIF connector that moves a mating electronic component to a fixed position before commencing the contact wipe action. During contact wipe, the electronic component cannot move and the contact areas and contact pins realise the benefit of a full wipe action.

A preferred embodiment is disclosed hereinafter in which an opposing pair of ZIF connectors used to connect to two substantially parallel edges of the same electronic component. Movement of the first actuator mechanism of the first connector moves the electronic component toward the opposite connector to fixed position. Continued movement of the first actuator mechanism causes contact pins in the first connector to engage and wipe contact area disposed along the edge of the electronic component adjacent the first connector.

Movement of a second actuator mechanism of the second connector does not move the electronic component but does cause contact pins in the second connector to engage and wipe contact areas disposed along the edge of the electronic component adjacent the second connector.

The first and second connectors are mechanically substantially identical so that either actuator mechanism can be moved first without affecting the integrity of the wipe action. This identity also lowers manufacturing costs by increasing product volume.

In another embodiment, electrical contact to a single edge of an electronic component can be effected by replacing one of the aforementioned opposing pair of connectors with a simple guideway. In this embodiment, the guideway acts as a mechanical stop for the electronic component during the actuation of the opposing connector.

The present invention will be described further by way of example with reference to the two embodiments thereof referred to, as illustrated in the accompanying drawings in which:

Fig. 1 is a perspective view of an opposing pair of ZIF connectors in partial engagement with a circuit board;

Fig. 2 is a sectional view corresponding to line 2-2 of Fig. 1;

Fig. 3 is a highly diagrammatic side view of the connector pair of Fig. 1 showing the actuator handle sequence;

Fig. 4 is a part sectional perspective view of an individual connector of Fig. 1; and

Fig. 5, in segments a-n, is a sequence of oversimplified pairs of mechanical schematics illustrating the positions of critical elements during the actuation sequence of the connector pair of Fig. 1, segments h-n being sectional views taken along lines H-H through N-N of segments a-g, respectively.

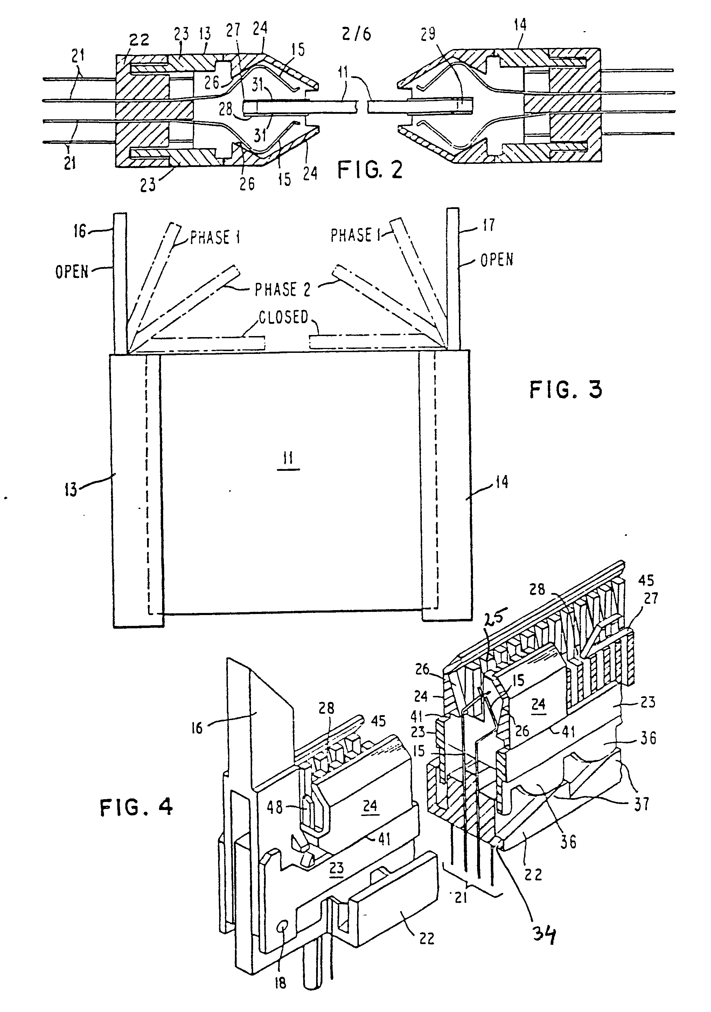

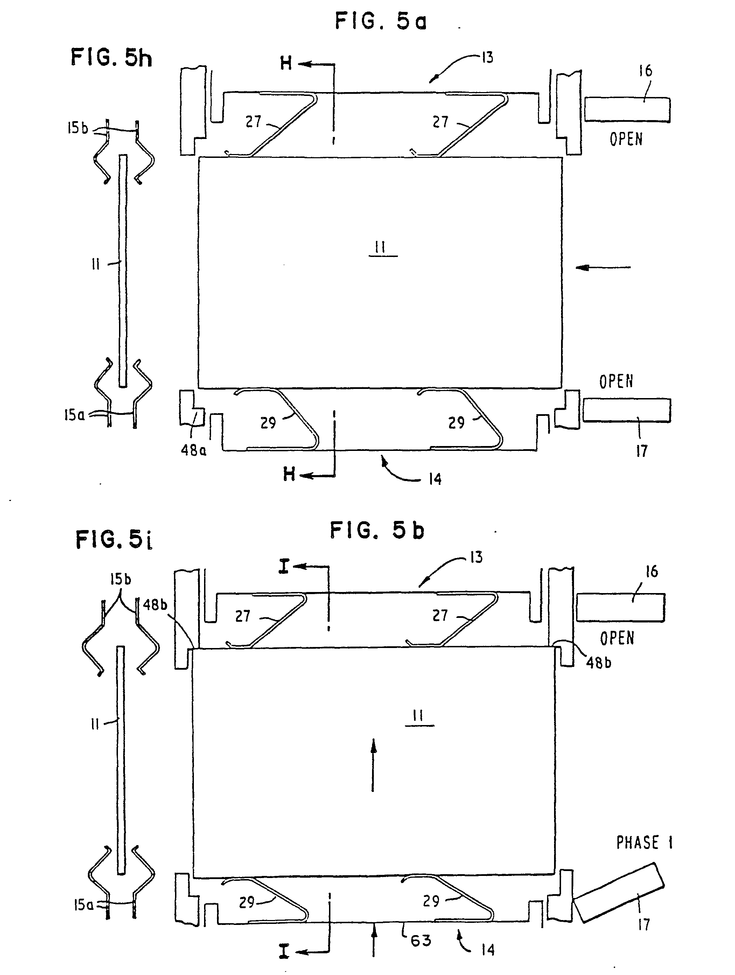

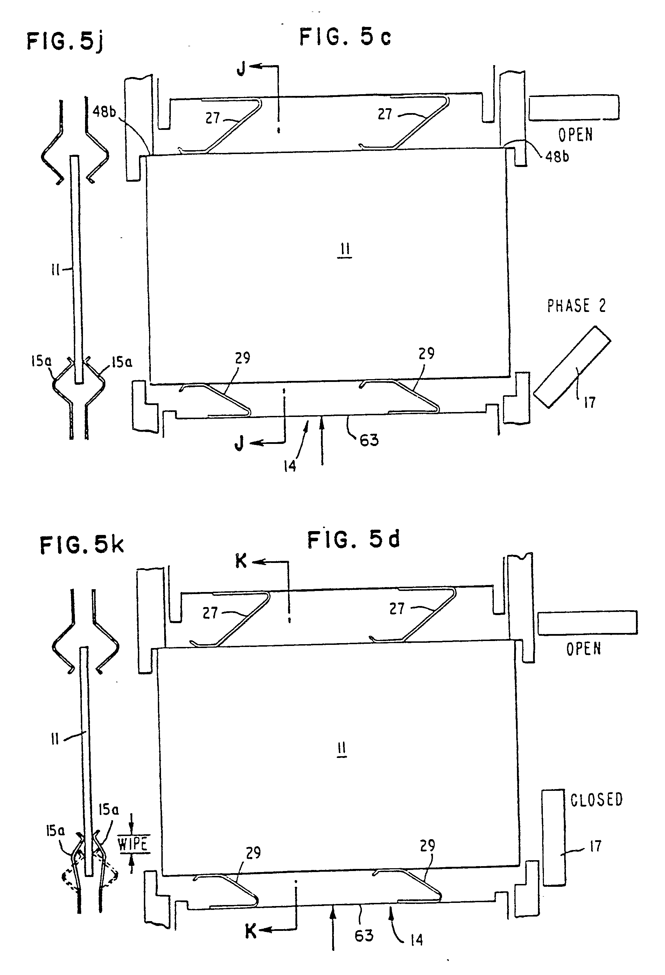

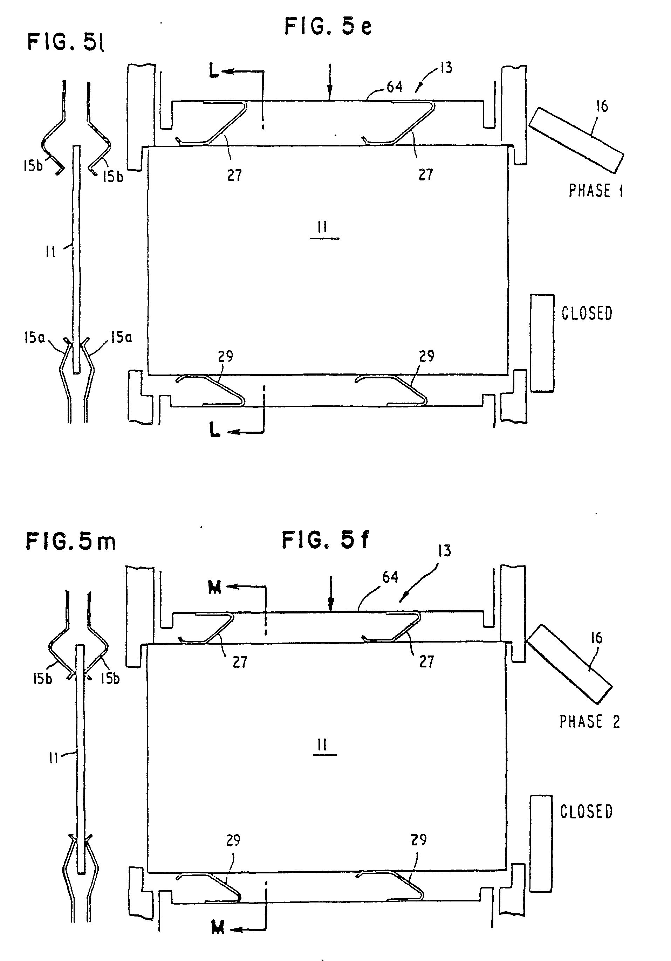

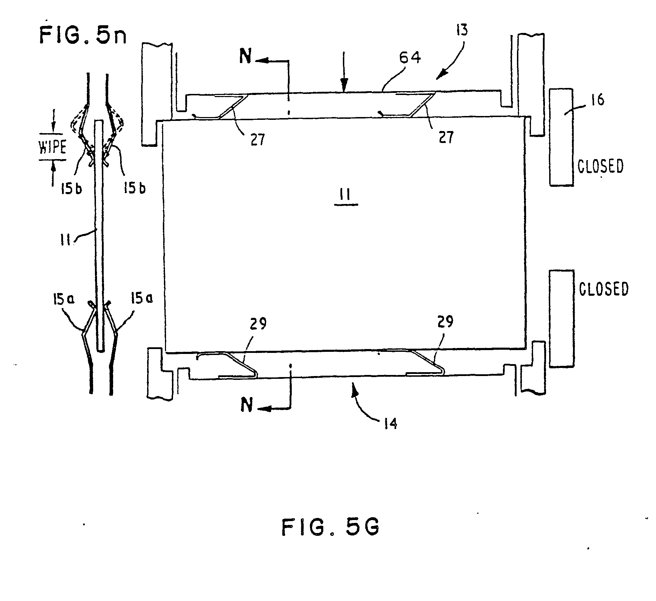

It must be appreciated that Figs. 3 and 5 are intended to illustrate specific points concerning the disclosed arrangement and make no pretence at being either accurate or realistic.

The connector assembly illustrated in the drawings connects with two substantially parallel edges of an electronic component carrier 11, which can be, for example, a printed circuit board, a ceramic substrate, a porcelanised steel substrate, or any other surface used to support electrical circuitry.

The carrier 11 has, disposed thereon, electronic components 12, which are, for example, resistive or capacitive elements or integrated circuits or any combination thereof. The components 12 are connected to electrical contact areas (not shown) located along two substantially parallel edges of carrier 11. Electrical connection between components 12 and the contact areas is provided by conductive circuit paths (not shown) placed on or under the surface of the carrier 11.

The carrier 11 is shown partially inserted into opposing electrical connectors 13 and 14. Connectors 13 and 14 both have, therein, rows of contact pins 15 for contacting the electrical contact areas along the edges of the carrier 11.

Contact pins 15 are moved into and out of a substantially planar insertion path (shown occupied by the carrier 11). Movement of actuator handles 16 and 17 of connectors 13 and 14 respectively causes pins 15 to move into and out of the insertion path. A detailed description of the actuation mechanism is presented below.

Handles 16 and 17 are both shown in the open position wherein pins 15 are retracted from the insertion path. This allows the carrier 11 to enter connectors 13 and 14 with so-called "zero insertion force".

When the carrier 11 is fully inserted into connectors 13 and 14, handles 16 and 17 are pivoted inwardly about hinge pins 18 and 19, respectively, thereby moving contact pins 15 toward the insertion path and into engaging contact with the contact areas located along the adjacent edges of the carrier 11.

Each contact pin 15 is electrically common with a respective conductor pin 21. Connectors 13 and 14 are typically mounted on mother boards (not shown) with their conductor pins 21 extending through vias in the mother boards.

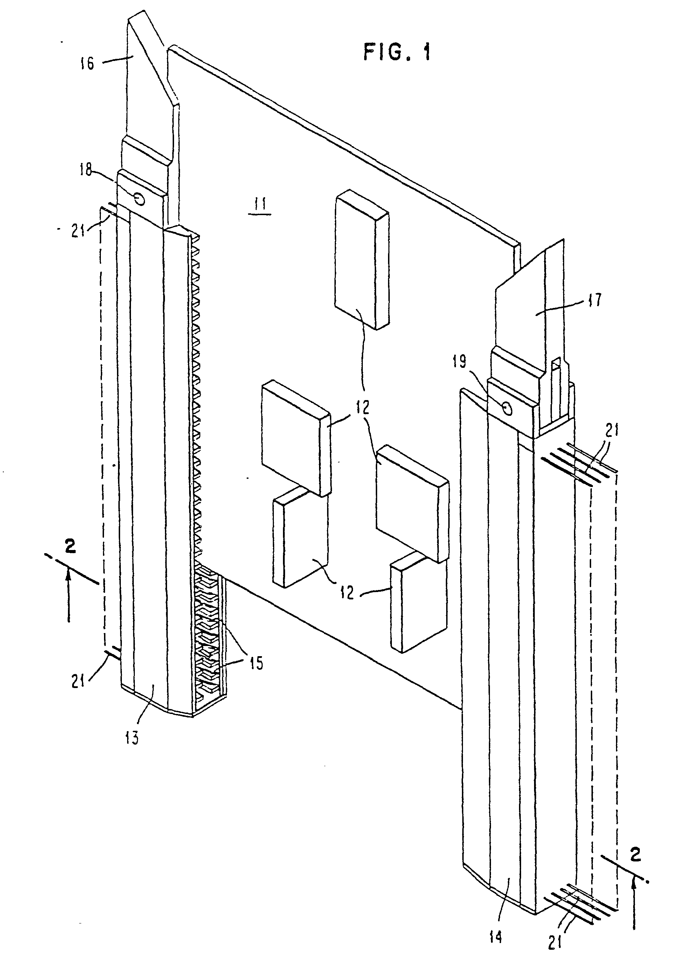

Connectors 13 and 14 as shown in Fig. 1, are mounted on individual mother boards, each motherboard being substantially parallel to the other, and substantially perpendicular to the carrier 11. Conductor pins 21 connect to electrical circuitry placed on the surface of the mother boards which, in turn, be connects to other carriers through other connectors mounted on the motherboards. By this arrangement, the electronic components 12 located on carrier 11 are electrically connected to an entire electrical system through contact pins 15 and conductor pins 21.

Connectors 13 and 14 are mechanically substantially identical and a description of only connector 13 will be given with the understanding that the description can be applied equally to connector 14.

Contact pins 15 extend through a base portion 22 and terminate at conductor pins 21. Contact pins 15 are formed so as to be self-biased away from the component insertion path shown occupied by carrier 11.

A linear cam 23, shown in its open position adjacent base portion 22 in Fig. 1, is effective on a housing 24 so as to move the housing away from base portion 22 as the linear cam 23 is moved longitudinally of and, hence, away from base portion 22 to its closed position as shown in Fig. 4, through the intermediate positions shown in Fig. 3. Inclined surfaces 26 formed internally of the housing 24 slideably engage contact pins 15 so that as housing 24 is moved away from base portion 22 by linear cam 23, the inclined surfaces 26 urge contact pins 15 toward the carrier insertion path. As the inclined surfaces 26 continue to move the pins 15 toward the insertion path, when a carrier is in place, pins 15 engage the carrier and effectively extend to wipe contact areas 31 located on the surface of the carrier 11.

A resilient member 27 occupies the bottom portion of a slot 28 in the housing 24. As the housing 24 moves away from base portion 22, the resilient member 27 compresses and also moves the carrier 11 away from connector 13 and toward connector 14. As the carrier 11 moves, a corresponding resilient member 29, located in connector 14, also partially compresses.

In the manner of a cartoon in Fig. 3, the carrier 11 is shown completely inserted into opposing connectors 13 and 14. For insertion and extraction of the carrier 11 into and out of connectors 13 and 14, actuator handles 16 and 17 are in the OPEN position. After the carrier 11 has been inserted, either handle 16 or 17 is moved, by an operator, from the OPEN position through the PHASE 1, PHASE 2, and to the CLOSED position as shown in broken line. The handle remaining in the OPEN position is then moved from OPEN through PHASE 1, PHASE 2 and to the CLOSED position, thereby completing the actuation sequence. Connectors 13 and 14 are mechanically substantially identical and either handle 16 or 17 can be moved first without affecting the integrity of the resultant electrical connection. This allows an unskilled operator to actuate the connector.

In Fig. 4, the actuator handle 16 is shown in the fully actuated or CLOSED position. The linear cam 23 is shown in the right-most position within base portion 22. To reach this position, handle 16 is rotated in a clockwise direction about hinge pin 18, causing linear cam 23 to move to the right within base portion 22. Cam lobes 36 on the housing 24 ride on cam followers 37 and force the linear cam 23 away from the base portion 22. During right-to-left motion of linear cam 23, caused by counter-rotation of the actuator handle, cam lobes 36 ride down cam followers 37 thereby allowing the linear cam 23 to move closer to base portion 22. Housing 24 is slideably engaged with linear cam 23 along surface 41. As the linear cam 23 moves toward or away from base portion 22, due to the co-action of cam lobes 36 and cam followers 37, housing 24 also moves toward or away from base portion 22. Sliding surface 41 does not transfer the linear right-to-left, or left-to-right, motion from the linear cam 23 to the housing 24.

Contact pins 15 effectively extend through base portion 34 and become conductor pins 21. Only one pair of contact pins 15 is shown in Fig. 4 in order not to obscure the figure.

The inclined surfaces 26, forming internal surfaces of housing 24, are slideably engaged with contact pins 15. As the housing 24 moves away from the base portion 22 during the actuation sequence, inclined surfaces 26 urge contact pins 15 toward the centre of slot 28 which occupies a portion of the aforementioned insertion path. Contact pins 15 are self-biased away from the insertion path and as the housing 24 moves toward base portion 22, pins 15 move away from the insertion path.

One skilled in the art will appreciate that other actuator mechanisms can be substituted for that specifically illustrated. Examples of other actuator mechanisms include rotating cams operated by a handle or tool as well as tool operated linear cams.

A resilient member 27 is located in the slot 28 in housing 24 defined by U-shaped spacers 25, interleaved with the inclined surfaces 26. The resilient member bears against the bottom portion of the slot defined by the bases of the spacers. The resilient member 27 can be, for example, an elastomer pad or, as shown, a formed metallic spring. A plurality of resilient members 27 will, typically, be spaced along the bottom portion of slot 28, if of any appreciable length, to provide a uniform force exerted along the edge of the carrier when inserted into slot 28.

A fixed stop 48 is located at each end of slot 28. The fixed stop 48 abuts the edge of a carrier, inserted in slot 28, after resilient members 27 have been partially compressed and is stepped to locate the corresponding corner of the carrier.

A description of the actuation sequence of the above described connector is best understood with reference to Fig. 5, of which, sections 5a-g are cartoons illustrating the positions of critical elements of the connectors during the actuation sequence, and sections 5h-n are sectional cartoons taken along sections H-H through N-N of Figs. 5a-g respectively, showing the relative positions of the carrier 11 and the contact pins 15.

Referring to Figs. 5a and 5h, the carrier 11 is shown fully inserted, from right to left, in opposing connectors 14 and 13. Actuator handles 17 and 16 are both in the OPEN position and connectors 14 and 13 are in the unactuated state. Resilient members 29 and 27 are in the uncompressed state and contact pins 15a and 15b are shown retracted from the insertion path (shown occupied by carrier 11).

In Figs. 5b and 5i, handle 17 of connector 14 is shown moved from the OPEN position to the PHASE 1 position. The slot base 63 of housing 24 is moved, by camming action previously described, in the arrow-marked direction, thereby compressing resilient members 29 and forcing the carrier 11 to move in the arrow-marked direction toward connector 13. The carrier 11, in turn, compresses resilient members 27 until it abuts fixed stops 48b in connector 13. The contact pins 15a and 15b do not move during this portion of the actuation sequence.

In Figs. 5c and 5j, handle 17 is shown moved to the PHASE 2 position causing the slot base 63 of connector 14 to move further in the arrow-marked direction thereby further compressing resilient members 29. The carrier 11 does not move because it abuts fixed stops 48b. As a result, resilient members 27 do not compress further. The inclined surfaces 26 force the contact pins 15a of connector 14 move toward the insertion path and engage contact areas (not shown) disposed on the edges of the major surfaces of carrier 11 adjacent connector 14.

In Figs. 5d and 5k, handle 17 is shown moved to the CLOSED position causing the slot base 63 of connector 14 to move further in the arrow-marked direction. Resilient members 29 compress further but the carrier 11 does not move and resilient members 27 do not compress further. Deformation of the contact pins 15a causes them to wipe the contact areas on the surface of electronic component 11. At the completion of the wipe, pins 15a grip the surface of the carrier 11 with a gripping force that is substantially normal to the surface thereof.

In Figs. 5e and 5l, handle 16 of connector 13 is shown moved from its OPEN position to its PHASE 1 position. This causes the slot base 64 of connector 13 to move in the arrow-marked direction thereby compressing resilient members 27. Because it is fully gripped by contact pins 15a, the carrier 11 does not move and resilient members 29 do not compress further. The static friction force on the surface of carrier 11 due to the gripping force of contact pins 15a combined with the force exerted on the edge of carrier 11 by resilient members 29 is sufficient to maintain the carrier 11 stationary. Contact pins 15b do not move during this portion of the actuation sequence.

In Figs. 5f and 5m, handle 16 is shown moved to its PHASE 2 position causing the slot base 64 of connector 13 to move further in the arrow-marked direction. Resilient members 27 compress further but the carrier 11 does not move. Contact pins 15b engage contact areas (not shown) disposed on the surface of the carrier 11 adjacent connector 13.

In Figs. 5g and 5n, handle 16 is shown moved to its CLOSED position causing slot base 64 of connector 13 to move further in the arrow-marked direction. Resilient members 27 compress further and contact pins 15b wipe the surface of the carrier 11 which does not move during this wipe action because the static friction force combined with the spring force of resilient members 29, is greater than the wiping force of pins 15b. At the completion of the wipe, pins 15b grip the surface of the carrier 11 with a gripping force that is substantially normal to the surface thereof the actuation sequence is complete.

If, in the fully open position of both connectors shown in Fig. 5a, handle 16 were moved first, carrier 11 would move away from connector 13 and toward connector 14 until abutting fixed stops 48a in connector 14. The actuation sequence would then proceed substantially as described above with the engaged/wipe action of pins 15b in connector 13 occurring before the engaged/wipe action of pins 15a in connector 14. The actuation sequence is, therefore, independent of the actuator handle timing sequence and either handle 17 or 16 can be moved first without affecting the integrity of the resultant electrical connection between pins 15a and 15b and contact areas on the surface of the carrier 11.

If the carrier 11 has contact areas disposed along only one edge, for example, the edge adjacent connector 14, connector 13 could be replaced by simple guideway having fixed stops 48b. The actuation sequence would then be completed at Fig. 5d because the substituted simple guideway has no contact pins therein and no actuator mechanism.

It should also be noted that opposing pairs of contact pins (e.g., opposing pair 15a and opposing pair 15b) are necessary if component 11 has contact areas disposed on two surfaces thereof. If component 11 has contact areas disposed on only one surface, contact pins would be required only for that surface. This would result in the connectors illustrated in the drawings having only a single row of contact pins instead of the double row shown.

Looked at another way, what has been described is a method for establishing electrical connection to two substantially parallel edges of an electronic component with a first and a second opposing zero insertion force type connector, each connector having electrical contacts therein, including the steps of:

applying a first force, $F_1$, to a first edge of the electronic component to move the component from the first connector toward the second connector to a fixed position;

engaging the electrical contacts in the first connector with the surface of the component adjacent the first edge;

wiping the electrical contacts in the first connector along the surface of the electronic component with a second force, $F_2$, in the same direction as $F_1$;

applying a first gripping force, $FG_1$, between the electrical contacts in the first connector and the surface of the component adjacent the first edge;

engaging the electrical contacts in the second connector with the surface of the component adjacent a second edge of the component; and

wiping the electrical contacts in the second connector along the surface of the component with a third force, $F_3$, substantially equal to and in the opposite direction of $F_2$, wherein $F_3$ is less than the sum of $F_1$ and the static friction force on the component due to $FG_1$.

A second gripping force, $FG_2$, may be applied between the electrical contacts in the second connector and the surface of the component adjacent the second edge.

## Claims

1. A connector assembly for locating two opposed edges of an electronic component carrier (11) and for making electrical edge connection between such carrier and the assembly while permitting zero insertion force entry of the carrier into the assembly, the assembly comprising a zero insertion force connector (13) in opposition to a slotted locator provided with a stop (48), the zero insertion force connector having actuator means (16;17), for advancing and closing contact pins (15), forming part thereof, onto such carrier, characterised in that resilient means (27) are provided in the zero insertion force connector, effective on a actuation of that connector, to bias such carrier onto the opposed stop before the contact pins of that connector can close on such carrier and, if the carrier is adapted to have electrical edge connection made to both located opposed edges, the locator is a second zero insertion force connector (14) and both connectors (13;14) are provided with resilient means (27;29) and stops (48a;48b).

2. A connector assembly for locating two opposed edges of an electronic component carrier (11) and for making electrical edge connection between such carrier and the assembly while permitting zero insertion force entry of the carrier into the assembly, the assembly comprising a pair of identical zero insertion force connectors (13;14) in opposition to each other, each being provided with actuator means, (16;17), for advancing and closing contact pins (15), forming part thereof, onto such carrier, characterised in that each connector is provided with a stop (48a;48b) and resilient means (27;29), the resilient means being effective on actuation of the connector on which such resilient means are mounted, to bias the carrier onto the stop of the opposed connector before the contact pins of the connector being actuated can close on such carrier.

3. A connector assembly as claimed in claim 2 wherein each connector (13;14) comprises a base portion supporting a moveable housing (24), the housing defining an elongated slot (28) for receiving one edge of such carrier, and carrying at least one row of fixed electrical contacts (15) biased to leave the slot free, the housing carrying both the stop (48a;48b) and the resilient means (27;29) for that connecter together with closing means (26) effective on movement of the housing in the direction thereof to close, by moving the contacts against the bias, and, if such carrier is engaged in the connector, to deform the contacts to produce a wiping action, the relative positions of the resilient means and the closing means being such as to bring the resilient means into operation before the closing means comes into effect.

4. A connector assembly as claimed in claim 3 wherein the resilient means (27;29) is located at the bottom portion of the elongated slot (28) in the housing (24).

5. A connector assembly as claimed in claim 3 or claim 4 wherein the closing means (26) includes inclined surfaces, attached to the housing for slideably engaging the row or rows of contacts.

6. A connector assembly as claimed in any of claims 2 to 5 wherein the housing (24) is moveable in a direction substantially perpendicular with the longitudinal dimension of the elongated slot (28) in the housing.

7. A connector as claimed in any preceding claim wherein the resilient means (27;29) includes a plurality of metallic springs or elastomer pads.

8. A connector assembly as claimed in claim 3 or any claim appendant thereto, wherein the actuator means includes a rotatable handle (16;17), cam follower means (37) attached to the base portion and a linear cam (23), coupled to the handle, having camming means (36) slideably engaged with the cam follower means (37) and being longitudinally moveable within the base portion in response to the rotation of the handle.

**Patentansprüche**

1. Steckervorrichtung zum örtlichen Anordnen zweier gegenüberliegender Kanten eines elektronischen Bauelemententrägers (11) und zum Erstellen elektrischer Kantenverbindung zwischen dem Träger und der Vorrichtung, während der Träger mit Null-Kraft in die Vorrichtung eingesetzt werden kann, wobei die Vorrichtung einen Null-Kraft-Stecker (13) gegenüber einem geschlitzten Positionierer mit Anschlag (48) aufweist, wobei der Null-Kraft-Stecker Betätigungsvorrichtungen (16; 17) zum Vorwärtsbewegen und Schließen von Kontaktstiften (15) auf den Träger aufweist, welche Teil davon sind, dadurch gekennzeichnet, daß der Null-Kraft-Stecker Federn (27) aufweist, die auf Betätigung des Steckers reagieren, so daß der Träger auf den gegenüberliegenden Anschlag vorgespannt Wird, ehe die Kontaktstifte des Steckers an dem Träger anliegen, und daß, sobald der Träger elektrische Kantenverbindung zu beiden sich gegenüberliegenden Kanten hat, der Positionierer ein zweiter Null-Kraft-Stecker (14) ist und beide Stecker (13; 14) Federn (27; 29) und Anschläge (48a; 48b) aufweisen.

2. Steckervorrichtung zum örtlichen Anordnen zweier gegenüberliegender Kante eines elektronischen Bauelemententrägers (11) und zum Erstellen elektronsicher Kantenverbindung zwischen dem Träger und der Vorrichtung, während der Träger mit Null-Kraft in die Vorrichtung eingesetzt werden kann, wobei die Vorrichtung zwei identische, sich gegenüberliegende Null-Kraft-Stecker (13; 14) aufweist, welche jeweils Betätigungsvorrichtungen (16; 17) zum Vorwärtsbewegen und Schließen von Kontaktstiften (15) auf den Träger haben, welche Teil davon sind, dadurch gekennzeichnet, daß jeder Stecker einen Anschlag (48a; 48b) und Federn (27; 29) aufweist, wobei die Federn auf Betätigung des Steckers, auf dem sie befestigt sind, reagieren, so daß der Träger auf den Anschlag des gegenüberliegenden Steckers vorgespannt werden kann, ehe die Kontaktstifte des betätigten Steckers auf dem Träger schließen können.

3. Steckervorrichtung nach Anspruch 2, dadurch gekennzeichnet, daß jeder Stecker (13; 14) ein Sockelteil aufweist, welches ein bewegliches Gehäuse (24) trägt, wobei das Gehäuse einen länglichen Schlitz (28) zur Aufnahme einer Kante des Trägers definiert und mindestens eine Reihe feststehender elektrischer Kontakte (15), die so vorgespannt sind, daß der Schlitz offen bleibt, trägt, wobei das Gehäuse sowohl den Anschlag (48a; 48b) als auch die Federn (27; 29) für den Stecker zusammen mit Schließvorrichtungen (26) trägt, welche auf Bewegung des Gehäuses in ihre Richtung schließen, indem die Kontakte gegen die Vorspannung bewegt werden, und, sobald der Träger in den Stecker eingerastet ist, die Kontakte deformieren, so daß ein Schleifen erzeugt wird, wobei die relativen Positionen der Federn und der Schließvorrichtungen die Federn in Betrieb setzen, ehe die Schließvorrichtungen wirken.

4. Steckervorrichtung nach Anspruch 3, dadurch gekennzeichnet, daß die Feder (27; 29) sich im unteren Teil des länglichen Schlitzes (28) im Gehäuse (24) befindet.

5. Steckervorrichtung nach Anspruch 3 oder 4, dadurch gekennzeichnet, daß die Schließvorrichtung (26) schräge Oberflächen aufweist, welche am Gehäuse befestigt sind, so daß sie bewegbar in die Reihe bzw. Reihen von Kontakten einrasten können.

6. Steckervorrichtung nach einem der Ansprüche 2 bis 5, dadurch gekennzeichnet, daß das Gehäuse (24) in eine Richtung bewegbar ist, welche im wesentlichen senkrecht zur Ausdehnung des länglichen Schlitzes (28) im Gehäuse ist.

7. Stecker nach einem der vorhergehenden Ansprüche, dadurch gekennzeichnet, daß die Feder (27; 29) eine Vielzahl von Metallfedern bzw. Elastomerfeldern aufweist.

8. Steckervorrichtung nach Anspruch 3 oder einem sich darauf beziehenden Anspruch, dadurch gekennzeichnet, daß die Betätigungsvorrichtung einen drehbaren Griff (16; 17), einen am Sockel befestigten Nockenstößel (37) und einen linearen, am Griff befestigten Nocken (23) mit Sägezähnen (36), welche mit dem Nockenstößel (37) in Gleitkontakt stehen und innerhalb des Sockels als Reaktion of die Drehbewegung des Griffs in Längsrichtung bewegbar sind, aufweist.

## Revendications

1. Montage de connecteur pour mettre en place deux bords opposés d'un support (11) de composants électroniques et pour établir une connexion électrique de bord entre un tel support et le montage, permettant dans le même temps une introduction, avec une force d'insertion nulle, du support dans le montage, le montage comprenant un connecteur (13), à force d'insertion nulle, situé à l'opposé d'un positionneur à fente fourni avec une butée (48), le connecteur à force d'insertion nulle comportant un moyen (16; 17) d'actionnement, servant à faire avancer et à fermer les broches (15) de contact, qui en font partie intégrante, sur ce support, caractérisé en ce que des moyens (27) élastiques sont prévus dans le connecteur de force d'insertion nulle, mis en oeuvre par un actionnement de ce connecteur, ayant pour rôle de pousser le support sur la butée opposée avant que les broches de contact de ce connecteur puisse se refermer sur un tel support et, si le support est adapté pour comporter une connexion électrique de bord placée sur les deux bords en position opposée, le positionneur est un second connecteur (14) à force d'insertion nulle, et deux connecteurs (13; 14) sont fournis avec des moyens (27; 29) élastiques et des butées (48a; 48b).

2. Montage de connecteur pour mettre en place deux bords opposés d'un support (11) de composants électroniques et pour établir une connexion électrique de bord entre un tel support et le montage permettant dans le même temps l'introduction, avec une force d'insertion nulle, du support dans le montage, le montage comprenant une paire de connecteurs (13; 14) identiques à force d'insertion nulle situés en opposition l'un par rapport à l'autre, chacun étant pourvu de moyens (16; 17) d'actionnement servant à faire avancer et à fermer les broches (15) de contact, qui en font partie intégrante, sur un tel support, caractérisé en ce que chaque connecteur est pourvu d'une butée (48a; 48b) et de moyens (27; 29) élastiques, le moyen élastique étant mis en oeuvre par un actionnement du connecteur sur lequel lesdits moyens élastiques sont montés, afin de pousser le support sur la butée du connecteur opposé avant que les broches de contact du connecteur mis en action, puissent se refermer sur ledit support.

3. Montage de connecteur tel que revendiqué à la revendication 2, dans lequel chaque connecteur (13; 14) comprend une partie inférieure supportant un logement (24) déplaçable, le logement délimitant une fente (28) longue destinée à recevoir un bord d'un tel support, et supportant une rangée au moins de contacts (15) électriques fixes poussés afin de dégager la fente, le logement supportant à la fois la butée (48a; 48b) et les moyens (27; 29) élastiques correspondant à ce connecteur, ainsi que des moyens (26) de fermeture mis en oeuvre au moment du déplacement du logement dans la direction de fermeture de ceux-ci, en déplaçant les contacts à l'encontre de la poussée, et, dans le cas où un tel support est engagé dans le connecteur, de déformer les contacts pour produire une action d'essuyage, les positions relatives des moyens élastiques et des moyens de fermeture étant telles qu'elles mettent les moyens élastiques en action avant que les moyens de fermeture ne produisent leur effet.

4. Montage de connecteur tel que revendiqué à la revendication 3, dans lequel les moyens (27; 29) élastiques sont situés au niveau de la partie inférieure de la fente (28) longue située dans le logement (24).

5. Montage de connecteur tel que revendiqué à la revendication 3 ou 4, dans lequel les moyens (26) de fermeture comprennent des surfaces inclinées, fixées au logement pour engager de manière coulissante la ou les rangée(s) de contact.

6. Montage de connecteur tel que revendiqué dans l'une quelconque des revendications 2 à 5, dans lequel le logement (24), est déplaçable dans une direction sensiblement perpendiculaire à la dimension longitudinale de la fente (28) longue située dans le logement.

7. Connecteur tel que revendiqué dans l'une quelconque des revendications précédentes, dans lequel les moyens (27; 29) élastiques comprennent une multiplicité de ressorts métalliques ou de bourrelets d'élastomère.

8. Montage de connecteur tel que revendiqué dans la revendication 3, ou l'une quelconque des revendications qui en dépendent, dans lequel les moyens d'actionnement comprennent une poignée (16; 17) pouvant tourner, un moyen (37) de suiveur, fixé à la partie inférieure et une came (23) linéaire, couplée à la poignée, comportant un moyen (36) formant came, engagé de manière coulissante dans le moyen (37) suiveur et déplaçable longitudinalement à l'intérieur de la partie inférieure en réponse à la rotation de la poignée.

FIG. 1

2/6

**FIG. 2**

**FIG. 3**

PHASE 1   PHASE 1

OPEN   OPEN

PHASE 2

CLOSED

11

**FIG. 4**

FIG. 5a

FIG. 5h

FIG. 5i

FIG. 5b

3

FIG. 5j

FIG. 5c

FIG. 5k

FIG. 5d

FIG. 5l

FIG. 5e

15b

15b

11

15a    15a

L

64    13

27    27

16

PHASE 1

11

CLOSED

29    29

L

FIG.5m

FIG. 5f

15b    15b

11

M

64    13

27    27

16

PHASE 2

11

CLOSED

29    29

M

5

FIG. 5n

FIG. 5G